# FASCICULE DE BREVET EUROPEEN

(11) **EP 4 100 626 B1**
(45) Date de publication et mention de la délivrance du brevet: **17.12.2025**
(21) Numéro de dépôt: 21707331.1
(22) Date de dépôt: 01.02.2021
(51) Int. Cl.: F01D 5/28, C23C 4/08, C30B 29/52, C22C 19/05, C23C 10/52, C23C 10/60, C23C 28/00

(54) **PIECE DE TURBOMACHINE REVETUE AYANT UN SUBSTRAT BASE NICKEL COMPRENANT DE L'HAFNIUM**
BESCHICHTETES TURBOMASCHINENTEIL MIT EINEM NICKELBASIERTEN SUBSTRAT, DAS HAFNIUM ENTHÄLT
COATED TURBOMACHINE PART HAVING A NICKEL-BASED SUBSTRATE COMPRISING HAFNIUM

(30) Priorité: 06.02.2020 FR 2001165
(43) Date de publication de la demande: 14.12.2022
(73) Titulaire: SAFRAN AIRCRAFT ENGINES, 75015 Paris (FR); SAFRAN, 75015 Paris (FR); Centre National de la Recherche Scientifique, 75016 Paris (FR); Universite De La Rochelle, 17000 La Rochelle (FR)
(72) Inventeur: DELAUTRE, Joel, 77550 MOISSY-CRAMAYEL (FR); HAMADI, Sarah, 77550 MOISSY-CRAMAYEL (FR); PASQUET, Annie, 77550 MOISSY-CRAMAYEL (FR); JAQUET, Virginie, 77550 MOISSY-CRAMAYEL (FR); PEDRAZA DIAZ, Fernando, 17000 LA ROCHELLE (FR); AUDIC, Christophe, Philippe, 77550 MOISSY-CRAMAYEL (FR)
(74) Mandataire: Cabinet Beau de Loménie
(86) Numéro de dépôt international: PCT/FR2021/050180
(87) Numéro de publication internationale: WO 2021/156562

(56) Documents cités:
- EP-A1- 1 652 964
- EP-A1- 2 963 135
- US-A1- 2015 377 037

## Description

### Domaine Technique

La présente invention concerne le domaine des superalliages à base nickel et plus précisément les superalliages utilisés dans le domaine aéronautique.

### Technique antérieure

Les superalliages à base nickel sont connus pour avoir d'une part une résistance mécanique élevée même à haute température, et d'autre part une bonne résistance à l'oxydation. Pour ces deux propriétés, ils représentent un matériau de choix pour les pièces de turbomachines utilisées dans le domaine aéronautique.

Parmi les superalliages à base nickel connus, on peut notamment citer l'alliage de dénomination commerciale AM-1 correspondant à la composition décrite dans le document US 4,639,280. Les documents EP1652964A1, EP2963135A1 et US2015/377037A1 concernent d'autres matériaux de l'état de la technique. EP1652964A1 présente avec le matériau René N5 l'état de la technique le plus proche, avec une teneur massique en carbone comprise entre 300 et 700 ppm.

La résistance à l'oxydation des superalliages peut être renforcée encore davantage grâce à des revêtements formés à leur surface. Néanmoins, même avec de tels revêtements, les alliages à base d'AM-1 disponibles actuellement finissent par s'oxyder lorsqu'ils sont utilisés dans une turbomachine. Ainsi, il demeure souhaitable d'améliorer encore la résistance à l'oxydation des superalliages pour pièce de turbomachine.

### Exposé de l'invention

Pour cela, les inventeurs proposent une pièce de turbomachine selon la revendication 1.

De préférence, la teneur massique en hafnium est inférieure ou égale à 15000 ppm.

L'invention propose une pièce de turbomachine formée par un substrat ayant une composition proche de l'AM-1 mais modifiée de sorte à présenter une teneur en hafnium relativement élevée, d'au moins 2000 ppm, et revêtu par un aluminure de de nickel de structure β. Les inventeurs ont constaté que cette pièce formée d'un tel substrat revêtu par ce revêtement spécifique, présente une résistance à l'oxydation particulièrement élevée. Sans vouloir être liés par la théorie, les inventeurs considèrent que la teneur limitée en carbone dans le substrat participe à améliorer la résistance à l'oxydation de la pièce en faisant en sorte que l'hafnium soit disponible pour migrer vers la surface et former un oxyde protecteur, plutôt que d'être piégé sous forme de carbure dans le matériau.

De manière préférée, la teneur massique en hafnium du substrat peut être supérieure ou égale à 4000 ppm.

Dans un mode de réalisation préféré, la teneur massique en hafnium du substrat peut être supérieure ou égale à 6000 ppm.

Les inventeurs ont constaté que, plus la teneur en hafnium est élevée, meilleure est la résistance à l'oxydation.

Dans un mode de réalisation, le superalliage est monocristallin. Un superalliage monocristallin permet une migration plus rapide et en plus grande quantité de l'hafnium vers la surface puisque l'hafnium n'est pas piégé par le carbone généralement introduit pour stabiliser les joints de grains d'un alliage polycristallin. Ceci améliore davantage encore la protection conférée par l'hafnium et donc la résistance à l'oxydation de la pièce.

Dans un mode de réalisation, le revêtement en aluminure de nickel de structure β peut être du NiAl de structure β. On notera que d'une manière générale le revêtement en aluminure de nickel de structure β peut ou non être modifié par un ou plusieurs éléments, par exemple le platine, le zirconium ou l'hafnium. Ainsi, à titre de revêtement en aluminure de nickel de structure β convenant pour l'invention on peut notamment citer le NiAl de structure β, le NiPtAl de structure β, le NiAlZr de structure β et le NiAlHf de structure β.

Dans un mode de réalisation, le revêtement en aluminure de nickel de structure β est un revêtement de NiAl de structure β ou un revêtement de NiPtAl de structure β.

Le revêtement en aluminure de nickel de structure β peut être formé par une méthode connue en soi. Par exemple, la formation de l'aluminure de nickel de structure β peut notamment être réalisée par dépôt physique en phase vapeur, par dépôt chimique en phase vapeur, par cémentation en caisse ou encore par voie barbotine.

Dans un mode de réalisation, une pièce de turbomachine selon l'invention peut comprendre en outre une barrière thermique présente sur le revêtement en aluminure de nickel de structure β.

Une telle barrière thermique est connue en soi, et permet de protéger la pièce de turbomachine contre les fortes températures qu'elle rencontre lors de son utilisation.

Dans un mode de réalisation, la barrière thermique peut être présente au contact du revêtement en aluminure de nickel de structure β.

Dans un mode de réalisation, la pièce de turbomachine peut être un distributeur de turbomachine ou un secteur de distributeur de turbomachine. Le distributeur peut être un distributeur haute pression ou un distributeur basse pression.

Dans des modes de réalisation alternatifs, la pièce de turbomachine peut également être une aube mobile ou un secteur d'anneau de turbine.

Selon un autre de ses aspects, l'invention concerne encore une turbomachine comprenant une pièce telle que décrite ci-dessus.

### Brève description des figures

[Fig. 1] La figure 1 représente, de manière schématique et partielle, une portion d'un distributeur de turbomachine selon un mode de réalisation de l'invention.
[Fig. 2] La figure 2 représente, de manière schématique et partielle, une vue en section d'une pièce de turbomachine selon un mode de réalisation de l'invention.
[Fig. 3] La figure 3 est un résultat d'essai comparatif montrant les différences en termes de résistance à l'oxydation entre des pièces selon l'invention et des pièces hors invention.

### Description détaillée

La description va maintenant être faite au moyen de figures destinées à mieux comprendre l'invention mais ne devant aucunement être interprétées de manière limitative.

De manière classique, une turbine de turbomachine comporte des éléments fixes et des éléments mobiles. Les éléments mobiles peuvent être des roues mobiles porteuses d'aubes, et sont généralement intercalées entre des ensembles d'aubes fixes, également appelés distributeur. Le couple distributeur/roue mobile constitue un étage de turbine.

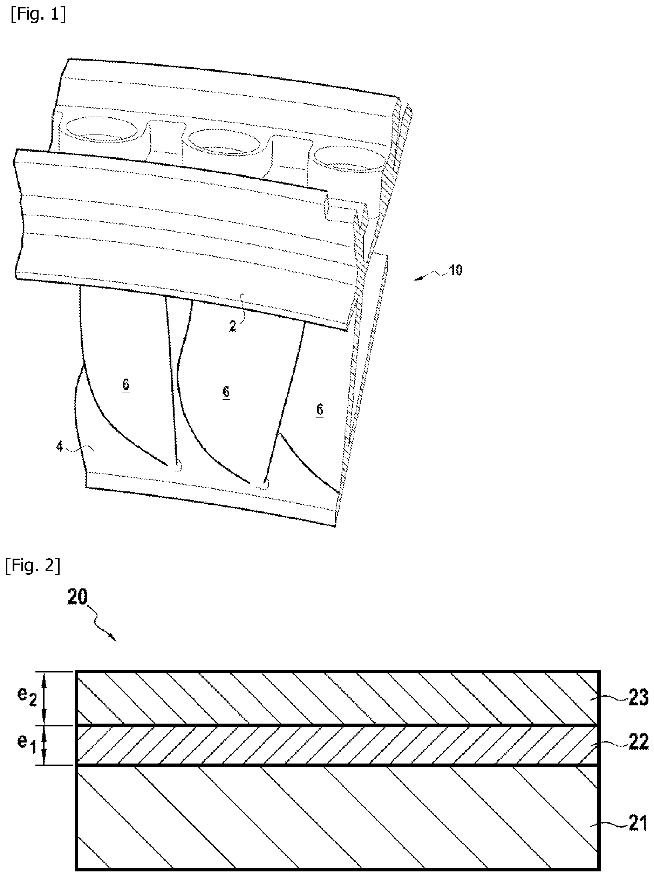

La figure 1 représente une portion d'un distributeur de turbomachine 10.

Un distributeur de turbomachine 10 peut comprendre une plate-forme extérieure 2 et une plate-forme intérieure 4, entre lesquelles s'étendent des aubes fixes 6, destinées à orienter le flux d'air dans une direction favorable à l'entraînement de la roue mobile adjacente, non représentée.

Sur la figure 2 est représentée de manière schématique une pièce de turbomachine 20 composée d'un substrat 21 et d'un revêtement 22 en aluminure de nickel de structure β qui recouvre le substrat 21 sous-jacent.

De plus, dans le mode de réalisation représenté, la pièce de turbomachine 20 comprend en outre une barrière thermique 23 au contact du revêtement 22 en aluminure de nickel de structure β. La barrière thermique 23 peut définir la surface externe de la pièce 20.

Dans un mode de réalisation, le revêtement 22 peut avoir une épaisseur e₁ comprise entre 40 µm et 90 µm.

De même, la barrière thermique 23 peut avoir une épaisseur e₂ comprise entre 50 µm et 300 µm.

Dans un mode de réalisation, la barrière thermique peut être choisie parmi une zircone partiellement stabilisée à l'yttrine ou un ou plusieurs autre(s) oxyde(s) de terre rare, une zircone dopée au dysprosium, du zirconate de gadolinium, une pérovskite.

Dans un mode de réalisation alternatif, la barrière thermique 23 peut être absente. Auquel cas, le revêtement 22 en aluminure de nickel de structure β peut définir la surface externe de la pièce.

### Exemple

Plusieurs échantillons d'AM-1 ont été enrichis avec une teneur massique d'hafnium allant de 340 ppm à 8000 ppm. On réalise ainsi des échantillons selon l'invention, lorsque le taux d'hafnium est supérieur ou égal à 2000 ppm et d'autres hors invention.

Les échantillons varient uniquement par leurs teneurs massiques en hafnium.

La teneur en hafnium des échantillons ainsi préparés est mesurée par spectrométrie de masse. Les échantillons sont revêtus par un revêtement en aluminure de nickel modifié platine NiPtAl de structure β. Chacun des échantillons est ensuite soumis à des cycles d'oxydation, et la variation de masse de chaque échantillon est mesurée trois fois par semaine pendant les 200 premiers cycles, puis deux fois par semaine au-delà.

Un cycle d'oxydation correspond à une chauffe très rapide jusqu'à la température d'oxydation (1150°C ±5 °C), un maintien à 1150°C sous pression atmosphérique d'air pendant 60 minutes et enfin un refroidissement forcé avec de l'air sec pendant 15 minutes de manière à s'assurer que la température de la pièce est inférieure à 150°C ± 3°C. L'essai est stoppé après 6000 cycles d'oxydation ou lorsqu'il est observé une variation de masse spécifique de 20 mg/cm².

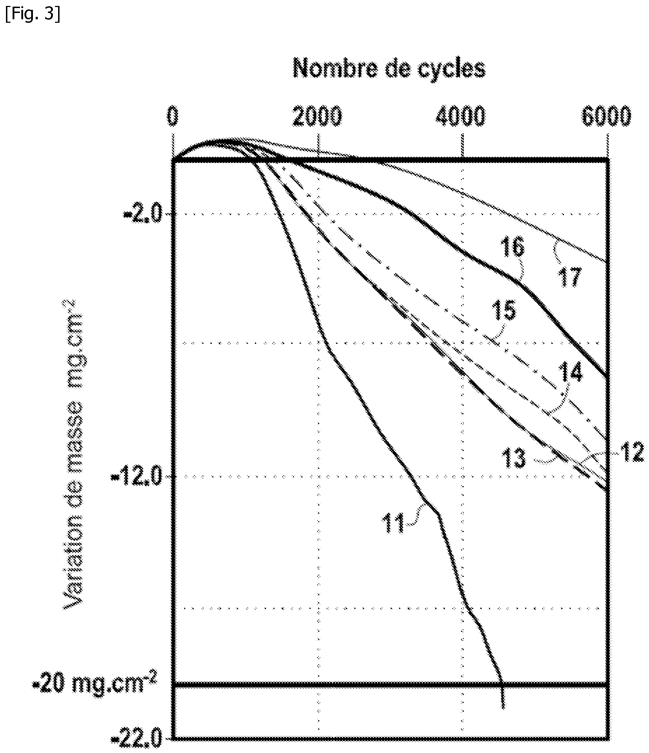

La figure 3 illustre les résultats obtenus pour chaque échantillon. Les teneurs massiques en hafnium des échantillons représentés sur la figure 3 sont pour la courbe 11 de 340 ppm, la courbe 12 de 780 ppm, la courbe 13 de 670 ppm, la courbe 14 de 1300 ppm, la courbe 15 de 2100 ppm, la courbe 16 de 4700 ppm et la courbe 17 de 8000 ppm.

Il peut être observé sur la figure 3 que les échantillons présentant une teneur en hafnium supérieure à 2000 ppm (15, 16, 17) sont également ceux pour lesquels la perte de masse est la moins importante. La forte teneur en hafnium permet donc une meilleure résistance à l'oxydation.

L'expression « compris(e) entre ... et ... » doit se comprendre comme incluant les bornes.

## Revendications

1. Pièce (20) de turbomachine comprenant :
(i) un substrat (21) en superalliage base nickel comprenant en teneur massique 5,0 % à 8,0 % de cobalt, 6,5 % à 10 % de chrome, 0,5 % à 2,5 % de molybdène, 5,0 % à 9,0 % de tungstène, 6,0 % à 9,0 % de tantale, 4,5 % à 5,8 % d'aluminium, de l'hafnium en une teneur massique supérieure ou égale à 2000 ppm, et comprenant du niobium en une teneur massique comprise entre 0% et 1,5 %, et l'un au moins du carbone, du zirconium et du bore chacun en une teneur massique comprise entre 0 ppm et 100 ppm, le complément étant composé par du nickel et des impuretés inévitables; et
(ii) un revêtement (22) en aluminure de nickel de structure β recouvrant le substrat.

2. Pièce (20) de turbomachine selon la revendication 1, dans laquelle la teneur massique en hafnium du substrat (21) est supérieure ou égale à 4000 ppm.

3. Pièce (20) de turbomachine selon la revendication 2, dans laquelle la teneur massique en hafnium du substrat (21) est supérieure ou égale à 6000 ppm.

4. Pièce (20) de turbomachine selon l'une quelconque des revendications 1 à 3, comprenant en outre une barrière thermique (23) présente sur le revêtement en aluminure de nickel de structure β.

5. Pièce (20) de turbomachine selon l'une quelconque des revendications 1 à 4, dans laquelle le revêtement (22) en aluminure de nickel de structure β est un revêtement de NiAl de structure β ou un revêtement de NiPtAl de structure β.

6. Pièce (20) de turbomachine selon l'une quelconque des revendications 1 à 5, dans laquelle le superalliage est monocristallin.

7. Pièce (20) de turbomachine selon l'une quelconque des revendications 1 à 6, dans laquelle ladite pièce est un distributeur (10) de turbomachine ou un secteur de distributeur de turbomachine.

8. Turbomachine comprenant une pièce (20) selon l'une quelconque des revendications 1 à 7.

## Patentansprüche

1. Teil (20) einer Turbomaschine, umfassend:
(i) ein Substrat (21) aus einer Superlegierung auf Nickelbasis, umfassend einen Massengehalt von 5,0 % bis 8,0 % Kobalt, 6,5 % bis 10 % Chrom, 0,5 % bis 2,5 % Molybdän, 5,0 % bis 9,0 % Wolfram, 6,0 % bis 9,0 % Tantal, 4,5 % bis 5,8 % Aluminium, Hafnium mit einem Massengehalt von mehr als oder gleich 2.000 ppm, und umfassend Niob mit einem Massengehalt zwischen 0 % und 1,5 %, und zumindest eines von Kohlenstoff, Zirkonium und Bor, jeweils mit einem Massengehalt zwischen 0 ppm und 100 ppm, wobei der Rest sich aus Nickel und unvermeidlichen Verunreinigungen zusammensetzt, und
(ii) eine Beschichtung (22) aus Nickelaluminid der β-Struktur, welche das Substrat bedeckt.

2. Teil (20) einer Turbomaschine nach Anspruch 1, wobei der Massengehalt des Substrats (21) an Hafnium höher als oder gleich 4.000 ppm ist.

3. Teil (20) einer Turbomaschine nach Anspruch 2, wobei der Massengehalt des Substrats (21) an Hafnium höher als oder gleich 6.000 ppm ist.

4. Teil (20) einer Turbomaschine nach einem der Ansprüche 1 bis 3, ferner umfassend eine thermische Barriere (23), die auf der Beschichtung aus Nickelaluminid der Struktur β vorliegt.

5. Teil (20) einer Turbomaschine nach einem der Ansprüche 1 bis 4, wobei die Beschichtung (22) aus Nickelaluminid der Struktur β eine Beschichtung aus NiAl der Struktur β oder eine Beschichtung aus NiPtAl der Struktur β ist.

6. Teil (20) einer Turbomaschine nach einem der Ansprüche 1 bis 5, wobei die Superlegierung monokristallin ist.

7. Teil (20) einer Turbomaschine nach einem der Ansprüche 1 bis 6, wobei das Teil ein Verteiler (10) einer Turbomaschine oder ein Sektor eines Verteilers einer Turbomaschine ist.

8. Turbomaschine umfassend ein Teil (20) nach einem der Ansprüche 1 bis 7.

## Claims

1. A turbomachine part (20) comprising:
(i) a nickel-based superalloy substrate (21) comprising, in mass content, 5.0% to 8.0% cobalt, 6.5% to 10% chromium, 0.5% to 2.5% molybdenum, 5.0 % to 9.0% tungsten, 6.0% to 9.0% tantalum, 4.5% to 5.8% aluminum, hafnium in a mass content greater than or equal to 2000 ppm, and comprising niobium in a mass content comprised between 0% and 1.5%, and at least one of carbon, zirconium and boron each in a mass content comprised between 0 ppm and 100 ppm, the remainder being composed of nickel and unavoidable impurities; and
(ii) a β-structured nickel aluminide coating (22) covering the substrate.

2. The turbomachine part (20) according to claim 1, wherein the hafnium mass content in the substrate (21) is greater than or equal to 4000 ppm.

3. The turbomachine part (20) according to claim 2, wherein the hafnium mass content in the substrate (21) is greater than or equal to 6000 ppm.

4. The turbomachine part (20) according to any one of claims 1 to 3, further comprising a thermal barrier (23) present on the β-structured nickel aluminide coating.

5. The turbomachine part (20) according to any one of claims 1 to 4, wherein the β-structured nickel aluminide coating (22) is a β-structured NiAl coating or β-structured NiPtAl coating.

6. The turbomachine part (20) according to any one of claims 1 to 5, wherein the superalloy is monocrystalline.

7. The turbomachine part (20) according to any one of claims 1 to 6, wherein said part is a turbomachine distributor (10) or a turbomachine distributor sector.

8. A turbomachine comprising a part (20) according to any one of claims 1 to 7.
